Europäisches Patentamt

European Patent Office

Office européen des brevets

(11) Veröffentlichungsnummer: **0 099 525**
A2

## (12) EUROPÄISCHE PATENTANMELDUNG

(21) Anmeldenummer: 83106694.9

(22) Anmeldetag: 08.07.83

(51) Int. Cl.³: **G 03 F 7/10**

(30) Priorität: 23.07.82 DE 3227584

(43) Veröffentlichungstag der Anmeldung:
01.02.84 Patentblatt 84/5

(84) Benannte Vertragsstaaten:
AT CH DE FR GB IT LI NL SE

(71) Anmelder: Merck Patent Gesellschaft mit beschränkter Haftung
Frankfurter Strasse 250
D-6100 Darmstadt(DE)

(72) Erfinder: Klug, Rudolf, Dr.
Grünewaldstrasse 25
D-8750 Aschaffenburg(DE)

(72) Erfinder: Merrem, Hans-Joachim, Dr.
Grüner Weg 1
D-6104 Seeheim(DE)

(72) Erfinder: Neisius, Karl Heinz, Dr.
Kattreinstrasse 76
D-6100 Darmstadt(DE)

(72) Erfinder: Härtner, Hartmut, Dr.
Mathildenweg 9
D-6109 Mühltal(DE)

(54) Fotolacke.

(57) Fotolacke zur Ausbildung von Reliefstrukturen aus hochwärmebeständigen Polymeren, die esterartig an Carboxylgruppen gebundene strahlungsreaktive Reste tragende, lösliche polymere Vorstufen enthalten, zeigen eine erhöhte Lichtempfindlichkeit, wenn mindestens 3 % der esterartig an Carboxylgruppen gebundenen strahlungsreaktiven Reste mehrwertige Alkohole zugrunde liegen, in denen eine oder mehrere Hydroxygruppen mit Allylalkohol und/oder Allylthiol verethert sind und die zur Veresterung eine freie Hydroxygruppe enthalten.

EP 0 099 525 A2

Croydon Printing Company Ltd.

Merck Patent Gesellschaft

mit beschränkter Haftung

D a r m s t a d t


Fotolacke

Die Erfindung betrifft Fotolacke zur Ausbildung von Reliefstrukturen aus hochwärmebeständigen Polymeren mit erhöhter Lichtempfindlichkeit. Fotolacke zur Ausbildung von Reliefstrukturen aus hochwärmebeständigen Polymeren werden in großem Umfang bei der Herstellung elektrischer und elektronischer Bauelemente, von Ätzreserven und Galvanikreserven oder von Druckformen verwendet. Für diese Zwecke gut verwendbare Fotolacke sind z. B. in der DE-PS 2 308 830 beschrieben. Diese enthalten strahlungsempfindliche polymere Vorstufen. Sie werden auf ein Substrat in Form einer Schicht oder Folie aufgetragen, die Schicht oder Folie wird getrocknet und dann durch eine Negativvorlage bestrahlt. An den bestrahlten Stellen findet dadurch eine Vernetzung statt, die die Löslichkeit des aufgetragenen Materials dort drastisch verringert. Die nicht bestrahlten Schicht- oder Folienteile werden dann in geeigneter

- 2 -

Weise durch Herauslösen oder Abziehen entfernt;
die verbleibenden Reliefstrukturen können dann durch
Tempern in hochwärmebeständige Polymere übergeführt
werden, die Temperaturen von 250 - 400 $^{\circ}$ ohne nachteilige Auswirkung auf Kantenschärfe und Auflösungsvermögen überstehen.

Gemäß der DE-PS 2 308 830 sind die löslichen polymeren Vorstufen (Präpolymeren) Polyadditions- oder
Polykondensationsprodukte aus (a) carbocyclischen
oder heterocyclischen Verbindungen mit zwei zu
Polyadditions- oder Polykondensationsreaktionen befähigten funktionellen Gruppen sowie teilweise in
ortho- oder peri-Stellung dazu esterartig an Carboxylgruppen gebundenen strahlungsreaktiven Resten
(im folgenden Ringverbindungen I genannt) und (b)
mit diesen funktionellen Gruppen umsetzbare Diamine,
Diisocyanate, Bis-säurechloride oder Dicarbonsäuren,
die mindestens ein cyclisches Strukturelement enthalten (im folgenden Ringverbindungen II genannt).
In der DE-PS 2308 830 sind eine Anzahl strahlungsreaktiver Reste aufgezählt, die für die Vernetzung des
Fotolackes bei der Bestrahlung verantwortlich sind.
Es wurde jedoch gefunden, daß zur ausreichenden Vernetzung dieser Fotolacke bei Bestrahlung mit einer
üblichen UV-Strahlenquelle Bestrahlungszeiten von
etwa 5 Minuten, meist sogar 8 bis 15 Minuten, erforderlich sind; diese Zeiten lassen sich auch
durch übliche Photosensibilisatoren nicht nennenswert verkürzen. Gemäß dem Zusatzpatent DE-PS 2 437 348
werden die Fotolacke nach der DE-PS 2 308 830 dahingehend modifiziert, daß als strahlungsreaktive
Gruppen Oxyalkylacrylat- bzw. Oxyalkylmethacrylatgruppen in die Ringverbindungen I eingebaut werden. Hierdurch wird eine Reduktion der notwendigen Bestrahlungszeiten auf durchschnittlich etwa 3 Minuten erreicht. Auch dies ist jedoch für die Verwendung derartiger Fotolacke in der Massenproduktion elektronischer Bauteile noch eine unerwünscht lange Bestrahlungsdauer.

Aufgabe der vorliegenden Erfindung ist die Modifizierung solcher Fotolacke derart, daß eine ausreichende Vernetzung der damit hergestellten Folien oder Schichten schon nach deutlich kürzeren Bestrahlungszeiten erzielt wird. Es wurde nun gefunden, daß überraschenderweise deutlich kürzere Bestrahlungszeiten bei derartigen Fotolacken ausreichend sind, wenn als strahlungsreaktive Gruppen esterartig an Carboxylgruppen gebundene Reste von mehrwertigen Alkoholen enthalten sind, in denen eine oder mehrere Hydroxygruppen mit Allyalkohol und/oder Allylthiol verethert sind und die in freiem Zustand mindestens eine freie Hydroxygruppe zur Veresterung enthielten. Durch den Einsatz von Präpolymeren mit solchen esterartig an Carboxylgruppen gebundenen strahlungsreaktiven Resten können die Bestrahlungszeiten auf mindestens zwei Drittel der bisher notwendigen verkürzt werden. Überraschenderweise wird eine deutliche Verkürzung der notwendigen Bestrahlungsdauer bereits beobachtet, wenn in einer löslichen polymeren Vorstufe der bisher bekannten Art, zum Beispiel gemäß der DE-PS 2 437 348, nur ein verhältnismäßig geringer Teil  - ab etwa 3 % - der üblichen strahlungsreaktiven Reste durch einen erfindungsgemäßen strahlungsreaktiven Rest ersetzt wird.

Gegenstand der Erfindung sind somit Fotolacke zur Ausbildung von Reliefstrukturen aus hochwärmebeständigen Polymeren, enthaltend esterartig an Carboxylgruppen gebundene strahlungsreaktive Reste tragende, lösliche polymere Vorstufen, die dadurch gekennzeichnet sind, daß mindestens 3 % der esterartig an Carboxylgruppen gebundenen strahlungsreaktiven Reste mehrwertige Alkohole zugrunde liegen, in denen eine oder mehrere Hydroxygruppen mit Allylalkohol und/oder Allylthiol verethert sind und die zur Veresterung eine freie Hydroxygruppe enthalten.

Gegenstand der Erfindung ist ferner die Verwendung von mehrwertigen Alkoholen, in denen eine oder mehrere Hydroxygruppen mit Allylalkohol und/oder Allylthiol verethert sind und die mindestens eine freie Hydroxygruppe enthalten, zur Herstellung von esterartig an Carboxylgruppen gebundene, strahlungsreaktive Reste tragenden, löslichen polymeren Vorstufen für Fotolacke.

Gegenstand der Erfindung ist weiterhin ein Verfahren zur Herstellung von Reliefstrukturen aus hochwärmebeständigen Polymeren durch Auftragen von Fotolacken, enthaltend esterartig an Carboxylgruppen gebundene strahlungsreaktive Reste tragende, lösliche polymere Vorstufen, in Form einer Schicht oder Folie auf ein Substrat, Trocknen der Schicht oder Folie, Bestrahlen der strahlungsempfindlichen Schicht oder Folie durch Negativvorlagen, Herauslösen oder Abziehen der nicht bestrahlten Schicht- oder Folienteile und gegebenenfalls anschließendes Tempern der erhaltenen

Reliefstrukturen, das dadurch gekennzeichnet ist, daß man Fotolacke verwendet, die esterartig an Carboxylgruppen gebundene strahlungsreaktive Reste tragende, lösliche polymere Vorstufen enthalten, bei denen mindestens 3 % dieser strahlungsreaktiven Reste mehrwertige Alkohole zugrunde liegen, in denen eine oder mehrere Hydroxygruppen mit Allylalkohol und/oder Allylthiol verethert sind und die zur Veresterung eine freie Hydroxygruppe enthalten.

Die in den erfindungsgemäßen Fotolacken enthaltenen löslichen polymeren Vorstufen entsprechen bis auf den teilweisen oder vollständigen Ersatz der üblichen strahlungsreaktiven Reste durch die erfindungsgemäßen strahlungsreaktiven Reste den üblichen löslichen polymeren Vorstufen, die sich durch Bestrahlen und gegebenenfalls Tempern in hochwärmebeständige Polymere überführen lassen. Solche löslichen polymeren Vorstufen sind beispielsweise in den DE-PS 23 08 830 und 24 37 348, DE-PS 24 37 368 und DE-PS 24 37 422 beschrieben. Dabei handelt es sich in der Regel um Polyadditions- bzw. Polykondensationsprodukte aus einer Ringverbindung I, die zwei esterartig an Carboxylgruppen gebundene strahlungsreaktive Gruppen sowie zwei für Additions- oder Kondensationsreaktionen geeignete Carboxyl-, Carbonsäurechlorid-, Amino-, Isocyanat- oder Hydroxylgruppen bzw. durch einfache Reaktionen in solche umwandelbare Gruppen enthält, und einer geeigneten Ringverbindung II mit mindestens einem cyclischen Strukturelement, wie einem Diamin, einem Diisocyanat, einer Dicarbonsäure oder einem Bis-säurechlorid. Als Ringverbindungen I werden erfindungsgemäß Polycarbonsäuren, insbesondere mit vier Carboxylgruppen, oder ihre Anhydride, Säurehalogenide und Partialester, wie Pyromellitsäure oder Bicyclo-[2.2.2] -octen-(7)-tetracarbonsäure (2,3,5,6) oder deren Derivate, aber auch Dihydroxycarbonsäuren wie Bis-(4-hydroxy-3-carboxy-phenyl)-methan oder Diaminodicarbonsäuren wie 4,4'-Diamino-3,3'-Dicarboxybiphenyl verwandt. Unter diesen ist Pyromellitsäure wegen ihrer leichten Zugänglichkeit und ihrer hohen chemischen Stabilität besonders bevorzugt. Sie wird vorzugsweise in die Synthesen der löslichen polymeren Vorstufen in Form ihres Dianhydrids eingesetzt.

Als Ringverbindungen II in den erfindungsgemäßen löslichen polymeren Vorstufen kommen alle bisher für diesen Zweck eingesetzten infrage, wobei die Natur der funktionellen Gruppen von der für die Polyadditions- oder Polykondensationsreaktion zur Verfügung stehenden Gruppen in den Ringverbindungen I abhängt. So werden beispielsweise Säurechloridgruppen in den Ringverbindungen I bevorzugt mit Diaminen umgesetzt, Carbonsäuregruppen, Aminogruppen und Hydroxygruppen mit Diisocyanaten, Aminogruppen auch mit Bis-Säurechloriden, Isocyanatgruppen mit Dicarbonsäuren.

Besonders bevorzugt als lösliche polymere Vorstufen sind Polykondensate aus Pyromellitsäure, die zwei esterartig an Carboxylgruppen gebundene strahlungsreaktive Reste trägt, und einem mindestens ein cyclisches Strukturelement enthaltenden Diamin, wie beispielsweise 4,4'-Diaminodiphenylether, 4,4-Diaminodiphenylmethan, 4,4'-Diaminodiphenylsulfon, 2,4-Diaminopyridin.

Die in den erfindungsgemäßen Fotolacken enthaltenen löslichen polymeren Vorstufen zeichnen sich dadurch aus, daß mindestens 3 % der esterartig an Carboxylgruppen gebundenen strahlungsreaktiven Reste mehrwertige Alkohole zugrunde liegen, in denen eine oder mehrere Hydroxygruppen mit Allylalkohol und/oder Allylthiol verethert sind und die zur Veresterung eine freie Hydroxygruppe enthalten. Als mehrwertige Alkohole, die das Grundgerüst dieser strahlungsreaktiven Reste bilden, kommen aliphatische, alicyclische oder aromatische Alkohole infrage. Bevorzugt sind aliphatische mehrwertige Alkohole, in denen die Kohlenstoffkette gerad- oder verzweigtkettig sein kann und 2 bis 8 C-Atome enthält. Dabei kann die Kohlenstoffkette auch ungesättigt und/oder gegebenenfalls durch Heteroatome wie Sauerstoff, Schwefel oder Stickstoff unterbrochen und/oder substituiert sein. Als Substituenten kommen solche infrage, die die Veresterungsreaktion nicht beeinflussen, wie beispielsweise aromatische Gruppen, wie Phenyl, oder Ketogruppen.

Insbesondere gehören zu diesen Alkoholen Ethylenglykol, 1,2- und 1,3-Propylenglykol, Glycerin, 1,2-, 1,3-, 1,4- und 2,4-Butandiol, 1,2,3- und 1,2,4-Butantriol, Erythrit, die Pentite wie Xylit, die Hexite wie Sorbit und Mannit, ferner auch verzweigtkettige wie Di- und Trimethylolethan und Pentaerythrit. Ferner sind auch durch eine Phenylgruppe substituierte Alkohole dieser Gruppe von Interesse, zum Beispiel Phenylethylenglykol, 1-Phenyl-2,3-dihydroxypropan, 1-Phenyl-1,2-dihydroxypropan, 1- oder 2-Phenylglycerin und 1-Phenyl-butandiol-(2,4). Die den strahlungsreaktiven Resten zugrunde liegenden mehrwertigen Alkohole besitzen das Grundgerüst dieser Alkohole, es sind jedoch darin eine oder mehrere Hydroxygruppen mit Allylalkohol und/oder Allythiol verethert; insgesamt können alle Hydroxygruppen bis auf eine so verethert sein. Eine Hydroxygruppe muß frei sein zur Ausbildung der Carbonsäureestergruppierung mit einer Carboxylfunktion der Ringverbindung I.

Erfindungsgemäß enthalten die löslichen polymeren Vorstufen strahlungsreaktive Reste, denen teilweise oder vollständig solche Mono- oder Oligo-allyl(thio) ether mehrwertiger Alkohole zugrunde liegen. Der Anteil der erfindungsgemäßen strahlungsreaktiven Reste beträgt mindestens 3 %, vorzugsweise mindestens 10 %, insbesondere mindestens 15 % der insgesamt vorhandenen strahlungsreaktiven Reste. Somit beträgt der Anteil der erfindungsgemäßen strahlungsreaktiven Reste in den löslichen polymeren Vorstufen insbesondere 15 bis 100 %. In den Fällen, in denen nur einem Teil der strahlungsreaktiven Reste die erfindungsgemäßen mehrwertigen Alkohole zugrunde liegen, wird der verbleibende Anteil von den üblichen strahlungsreaktiven Resten, wie sie in DE-PS 23 08 830, DE-PS 24 37 348 und DE-PS 24 37 422 beschrieben werden, gebildet. Dabei sind besonders esterartig an Carboxylgruppen gebundene strahlungsreaktive Oxyallyl-, Oxyalkylacrylat- und Oxyalkylmethacrylatgruppen, wie 2-Oxyethylacrylat- oder -methacrylatgruppen, bevorzugt:

Die in den erfindungsgemäßen Fotolacken enthaltenen löslichen polymeren Vorstufen haben in der Regel Molekulargewichte zwischen 2 000 und 100 000, vorzugsweise zwischen 4 000 und 60 000.

Die Herstellung der in den erfindungsgemäßen Fotolacken enthaltenen löslichen polymeren Vorstufen erfolgt analog zu dem in der DE-PS 2 308 830 beschriebenen Verfahren, indem zuerst in den Ringverbindungen I zwei Carboxylgruppen unter für derartige Reaktionen üblichen Bedingungen mit den die strahlungsreaktiven Reste tragenden Alkoholen verestert werden. Hierzu läßt man gewöhnlich eine Ringverbindung I oder ein reaktionsfähiges Derivat davon bei einer Temperatur zwischen -50°C bis +250°C, gegebenenfalls in Gegenwart eines organischen Lösungsmittels und/oder eines üblichen Veresterungskatalysators, mit den erforderlichen molaren Mengen der die strahlungsreaktiven Reste tragenden Alkoholen reagieren.

Reaktionsfähige Derivate der Ringverbindungen I sind insbesondere solche mit Säurehalogenidgruppen oder Säureanhydridgruppierungen. Wenn die Ringverbindung I als Carbonsäure eingesetzt wird, dient als Veresterungskatalysator vorzugsweise eine Säure. Bevorzugt ist jedoch die Reaktionsweise, bei der ein Säureanhydrid oder eine Säurehalogenid einer Ringverbindung I mit einem (oder mehreren) strahlungsreaktive Reste enthaltendem Alkohol(en) umgesetzt wird. Neben einem oder mehreren mehrwertigen Alkohl(en), in denen eine oder mehrere Hydroxygruppen mit Allylalkohol und/oder Allylthiol verethert sind und die noch mindestens eine freie Hydroxygruppe enthalten, können auch ein oder mehrere andere bekannte strahlungsreaktive Gruppen einführende Alkohole, beispielsweise Allylalkohol oder (2-Hydroxyethyl)-(meth)acrylat in die Veresterungsreaktion einbezogen werden. Vorzugsweise werden diese Veresterungsreaktionen in einem basischen Milieu durchgeführt, wobei als Basen insbesondere Alkalimetallhydroxide wie Natrium- oder Kaliumhydroxid, Alkalimetallcarbonate bzw. -hydrogencarbonate wie Natriumcarbonat, Natriumhydrogencarbonat, Kaliumcarbonat oder Kaliumhydrogencarbonat, Alkalimetallacetate wie Natrium- oder Kaliumacetat, Erdalkalimetallhydroxide wie Calciumhydroxid oder organische Basen wie Triethylamin, Pyridin, Lutidin, Kollidin oder Chinolin von Bedeutung sind. Die Veresterungen werden vorteilhaft in Gegenwart eines inerten Lösungsmittels durchgeführt. Gut geeignet sind insbesondere Ether wie Diethylether, Di-n-butylether, Tetrahydrofuran, Dioxan oder Anisol, Ketone wie Aceton, Butanon, Pentanon-(3) oder Cyclohexanon, Amide wie Dimethylformamid oder Hexamethylphosphorsäuretriamid, Kohlenwasserstoffe wie Benzol, Toluol oder Xylol, Halogenkohlenwasserstoffe wie Tetrachlorkohlenstoff oder Tetrachlorethylen und Sulfoxide wie Dimethylsulfoxid oder Sulfolan. Mit Wasser nicht mischbare Lösungsmittel können gleichzeitig vorteilhaft zum azeotropen Abdestillieren des bei der Veresterung gebildeten Wassers verwendet werden. Gelegentlich kann auch ein Überschuß einer verwendeten organischen Base, zum Beispiel Pyridin, Chinolin oder Triethylamin, als Lösungsmittel für die Veresterung angewandt werden.

Prinzipiell können die Veresterungsreaktionen auch in Abwesenheit eines Lösungsmittels, zum Beispiel durch einfaches Erhitzen der Komponenten in Gegenwart von Natriumacetat, durchgeführt werden.

Die Reaktionstemperatur liegt gewöhnlich zwischen -50° und +250°, vorzugsweise zwischen -20° und +80°. Bei diesen Temperaturen sind die Veresterungsreaktionen in der Regel nach 15 Minuten bis 96 Stunden beendet.

Der erhaltene Diester aus Ringverbindung I und dem (den) die strahlungsreaktive(n) Gruppe(n) einführenden Alkohol(en) wird anschließend, gegebenenfalls nach Modifizierung der noch freien funktionellen Gruppen, zum Beispiel Umwandlung einer Carboxylgruppe in eine Säurechloridgruppe mit einem geeigneten Chlorierungsmittel wie Thionylchlorid, mit einer Ringverbindung II in einer an sich bekannten Polyadditions- oder Polykondensationsreaktion zu der löslichen polymeren Vorstufe umgesetzt. Diese Umsetzungen erfolgen vorzugsweise durch portionsweises Zusetzen einer Lösung einer der Komponenten - in der Regel der Ringverbindung II - in einem starken polaren aprotischen Lösungsmittel wie zum Beispiel Dimethylformamid, Dimethylacetamid, Dimethylsulfoxid oder N-Methylpyrrolidon zu einer Lösung der anderen Komponente in einem ebensolchen Lösungsmittel. Abhängig von der Natur der an der Polyaddition oder Polykondensation beteiligten funktionellen Gruppen findet die Reaktion bei Temperaturen zwischen -20° und +100°, gegebenenfalls in Gegenwart eines Katalysators statt; sie ist in der Regel nach 15 Minuten bis 24 Stunden beendet. Aus dem Reaktionsgemisch wird die lösliche polymere Vorstufe in herkömmlicher Weise abgetrennt, zum Beispiel durch Ausfällen mit Wasser und Ab-filtrieren und gegebenenfalls gründlichem Aus-waschem nicht gewünschter Nebenprodukte.

Die so hergestellen löslichen polymeren Vorstufen
werden in an sich bekannter Weise zu den erfindungsgemäßen Fotolacken verarbeitet. Diese Fotolacke
können außer einem geeigneten Lösungsmittel und
der löslichen polymeren Vorstufe weitere in dieser
Technologie bekannte und übliche Zusatzstoffe enthalten. Als Beispiel seien Füllstoffe, Fotosensibilisatoren, Farbstoffe, Pigmente, Weichmacher, Haftvermittler, thermisch aktivierbare, freie Radikale
bildende Initiatoren genannt, ferner auch die verschiedensten anderen Polymeren und Harze, Stabilisatoren sowie oberflächenaktive Verbindungen, die
gegebenenfalls zur Verbesserung der filmbildenden
Eigenschaften oder Beschichtungseigenschaften beitragen können und/oder zur Verbesserung der Haftung
der auf die Substrate aufgetragenen Schichten, ferner
zur Verbesserung der mechanischen Festigkeit, der
chemischen Widerstandsfähigkeit, der Fließbeständigkeit
des Materials, aber auch zur Beeinflussung der Viskosität der Fotolacke. Solche Zusatzstoffe können
in einer Menge von 0 bis 15 Gew.%, bezogen auf den
Feststoffgehalt, zugesetzt werden.

Als Lösungsmittel, die die löslichen polymeren Vorstufen und die vorgenannten Bestandteile der Fotolacke lösen können, eignen sich beispielsweise
Ethylenglykol, Glykolether wie Glykolmonomethylether,
Glykoldimethylether und Glykolmonoethylether; aliphatische Ester wie Ethylacetat, Hydroxyethylacetat,
Alkoxyethylacetat, n-Butylacetat oder Amylacetat;
Ether wie Dioxan; Ketone wie Methylethylketon,
Methyl-iso-butylketon, Cyclopentanon und Cyclohexanon;

Dimethylformamid, Dimethylacetamid, Hexamethylphosphorsäuretriamid, N-Methylpyrrolidon, Butyrolacton und
Mischungen solcher Lösungsmittel. Diese Lösungen
enthalten in der Regel 5 bis 60 %, vorzugsweise
bis 50 % an Feststoffen. Die erfindungsgemäßen Fotolacke können in der üblichen Weise auf alle hierfür
gebräuchlichen Substrate aufgetragen werden, insbesondere auf an der Oberfläche thermisch oxidierte
und/oder mit Aluminium beschichtete Siliziummaterialien, die gegebenenfalls auch dotiert sein können,
ferner alle anderen in der Halbleitertechnologie
üblichen Substrate wie z. B. Siliziumnitrid, Galliumarsenid, Indiumphospid. Weiterhin kommen infrage
aus der Flüssigkristalldisplay-Herstellung bekannte
Substrate wie Glas, Indium-Zinn-oxid; ferner Metallplatten und -folien, beispielsweise aus Aluminium,
Kupfer, Zink; Bimetall- und Trimetallfolien, aber
auch elektrisch nicht leitende Folien, die mit Metallen bedampft sind, gegebenenfalls mit Aluminium
beschichtete $SiO_2$-Materialien, Papier. Diese
Substrate können einer Temperatur-Vorbehandlung
unterzogen werden, oberflächlich angerauht, angeätzt
oder zur Erhöhung der Hydrophilie mit Chemikalien
behandelt sein.

Die Fotolackschichten können in verschiedener
Stärke auf ein Substrat aufgetragen werden. Die
im Einzelfalle vorteilhafteste Schichtstärke hängt
von verschiedenen Faktoren ab, beispielsweise dem
speziellen Verwendungszweck des herzustellenden
Materials, der im Einzelfalle verwendeten polymeren Vorstufe und der Natur der anderen Komponenten, die gegebenenfalls in der strahlungsempfindlichen Schicht zugegen sein können. Als zweckmäßig hat es sich in der Regel erwiesen, wenn die Resistschichten eine Stärke von 0, 1 um bis 20 um aufweisen.

Der Auftrag der Fotolacke auf die saubere Oberfläche der Substrate kann durch Aufsprühen, Fließbeschichten, Walzen, Schleuderbeschichten und Tauchbeschichten erfolgen, wonach das Lösungsmittel durch Verdampfen entfernt wird, so daß auf der Oberfläche des Substrats eine strahlungsempfindliche Schicht zurückbleibt. Die Entfernung des Lösungsmittels kann gegebenenfalls durch Erhitzen der Schicht auf Temperaturen von bis zu 100° gefördert werden. Anschließend wird die Fotolackschicht der Strahlung ausgesetzt, welche die Reaktion der strahlungsreaktiven Gruppen unter Vernetzung der Schicht verursacht. Üblicherweise wird aktinisches Licht verwendet, aber auch energiereiche Strahlung wie Röntgen- oder Elektronenstrahlung. Die Bestrahlung oder Belichtung kann durch eine Maskenvorlage durchgeführt werden, es kann aber auch ein gebündelter Strahl der Strahlung über die Oberfläche der strahlungsempfindlichen Schicht geführt werden. Üblicherweise werden zur Bestrahlung UV-Lampen verwendet, die Strahlung einer Wellenlänge von 250 bis 400 nm und einer Intensität von 0,5 bis 60 mW/cm$^2$ aussenden. In der Schicht wird ein Bildmuster unter Freilegung von Teilen des Substrats entwickelt, indem die Schicht mit einer Entwicklerlösung behandelt wird, die die nicht bestrahlten Bereiche des Fotolackmaterials entfernt.

Als Entwicklerlösung wird in der Regel ein Gemisch aus einem oder mehreren der für die Herstellung des Fotolacks angegebenen Lösungsmittel mit einem Fällungsmittel verwendet. Typische Entwicklerlösungen sind beispielsweise 4-Butyrolacton/Toluol und Dimethylformamid/Ethanol, jeweils in Verhältnis 2:1 bis 1:4. Nach kurzer Bestrahlungsdauer, z. B. von nur 30 Sekunden, sowie Entwickeln, Waschen und Trocknen, werden kantenscharfe Resistbilder mit einer Auflösung von unter 3 $\mu$m erhalten, die durch Tempern bei 200 bis 400° in hochwärmebeständige Polymere überführt werden können.

Diese hochwärmebeständigen Polymeren haben ausgezeichnete chemische, elektrische und mechanische Eigenschaften. Die erfindungsgemäßen Fotolacke eignen sich somit beispielsweise zur Herstellung von Schutzschichten auf Halbleiterelementen, dielektrischen Schichten bei vielschichtigen integrierten Schaltungen, als letzte passivierende Schicht auf elektrischen Vorrichtungen. Die folgenden Beispiele erläutern die Herstellung der erfindungsgemäßen Fotolacke und ihre Anwendung.

Beispiel 1

(a) Herstellung der polymeren Vorstufe (Präpolymeres):

Eine Lösung von 18,5 g Pyromellitsäuredianhydrid, 8,7 g Pentaerythrittriallylether und 17,6 g (2-Hydroxyethyl)-methacrylat in 200 ml Tetrahydrofuran wird unter Rühren und Wasserkühlung bei Raumtemperatur allmählich mit 28 ml Pyridin versetzt, und das Reaktionsgemisch wird 3 Tage bei Raumtemperatur stehen gelassen. Anschließend wird unter kräftigem Rühren langsam 12 ml Thionylchlorid bei -10° bis -15° zugetropft und 3 Stunden bei der gleichen Temperatur nachgerührt. Zum Reaktionsgemisch wird dann bei -10° bis -15° eine Lösung von 13,5 g 4,4'-Diaminodiphenylether in 65 ml Dimethylacetamid getropft. Die Mischung wird über Nacht bei Raumtemperatur gerührt und anschließend mit wenig Acetylchlorid sowie mit etwa 50 ml Ethanol versetzt. Nach dem Stehen über Nacht wird die Lösung in 4 l Wasser eingerührt, das abgesaugte Präpolymere mit Wasser gewaschen und im Vakuum getrocknet.

In diesem Präpolymeren liegt etwa 80 % der esterartig an Carboxylgruppen gebundenen strahlungsreaktiven Reste (2-Hydroxyethyl)-methacrylat und etwa 20 % Pentaerythrittriallylether zugrunde.

(b)  Fotolack

  5     g     polymere Vorstufe nach (a)
  0,25 g     N-Phenyl-maleinimid
  0,1  g     Michlers Keton und
  0,05 g     Vinyltrimethoxysilan werden in 14,5 ml
             Dimethylacetamid gelöst.

(c)  Anwendung

Auf ein Substrat mit einer $SiO_2$-Oberfläche wird der Fotolack gemäß (b) aufgeschleudert und durch Erwärmen getrocknet. Die erhaltene 1,9 µm starke Schicht wird anschließend unter Stickstoff im Kontaktverfahren 30 Sekunden durch ein Strichraster mit einer 200 Watt UV-Lampe mit einer Intensität von 5 - 6 mW/cm$^2$bestrahlt.

Anschließend werden die nicht bestrahlten Fotolackteile durch Entwickeln mit einer Mischung aus
gleichen Volumenteilen Toluol und 4-Butyrolacton
ausgewaschen. Man erhält ein kantenscharfes Bild
mit einer Auflösung von weniger als 3 μm.

Beispiele 2 bis 5

Analog Beispiel 1 (a) werden polymere Vorstufen hergestellt, in denen die strahlungsreaktiven Gruppen
folgendermaßen zusammengesetzt sind:

Beispiel 2:   Etwa 75 % der esterartig an Carboxylgruppen gebundenen strahlungsreaktiven
Reste liegt (2-Hydroxyethyl)-methacrylat
und etwa 25 % Pentaerythrittriallylether zugrunde.

Beispiel 3:   Etwa 50 % der esterartig an Carboxylgruppen gebundenen strahlungsreaktiven
Reste liegt (2-Hydroxyethyl)-methacrylat
und etwa 50 % Pentaerythrittriallylether
zugrunde.

Beispiel 4:   Etwa 25 % der esterartig an Carboxylgruppen gebundenen strahlungsreaktiven
Reste  liegt (2-Hydroxyethyl)-methacrylat
und etwa 75 % Pentaerythrittriallylether
zugrunde.

Beispiel 5:    100 % der esterartig an Carboxylgruppen gebundenen strahlungsreaktiven Reste liegt Pentaerythrittriallylether zugrunde.

Die in den Beispielen 2 bis 5 genannten polymeren Vorstufen werden analog Beispiel 1 (b) jeweils zu einem Fotolack formuliert.

Bei der Anwendung analog Beispiel 1 (c) erhält man nach einer Bestrahlungsdauer von je 30 Sekunden identisch-kantenscharfe Bilder mit einer Auflösung von weniger als 3 µm.

Beispiel 6

Analog Beispiel 1 (a) werden 36,9 g Pyromellitsäuredianhydrid mit 8,6 g Glykolmonoallylether und 33 g (2-Hydroxyethyl)-methacrylat verestert. Der Ester wird anschließend in analoger Weise zu Beispiel 1 (a) mit 4,4'-Diaminodiphenylether umgesetzt. Man erhält eine polymere Vorstufe, in der etwa 75 % der esterartig an Carboxylgruppen gebundenen strahlungsreaktiven Reste (2-Hydroxyethyl)-methacrylat und etwa 25 % Glykolmonoallylether zugrunde liegt. Diese wird analog Beispiel 1 (b) zu einem Fotolack formuliert.

Dieser Fotolack wird auf ein Substrat mit einer $SiO_2$-Oberfläche aufgeschleudert, die Schicht wird durch Erwärmen getrocknet. Die erhaltene 1,5 µm starke Schicht wird anschließend unter Stickstoff im Kontaktverfahren durch ein Strichraster mit einer 200 Watt UV-Lampe mit einer Intensität von etwa 4 mW/cm$^2$ be-

GSPHA11 G-ib

strahlt. Nach Entwicklung analog Beispiel 1 (c) erhält man ein kantenscharfes Bild mit einer Auflösung von weniger als 3 µm.

Beispiel 7

Analog Beispiel 1 (a), jedoch unter Verwendung von Glycerindiallylether anstelle von Pentaerythrittriallylether, wird eine polymere Vorstufe hergestellt, in der etwa 75 % der esterartig an Carboxylgruppen gebundenen strahlungsreaktiven Reste (2-Hydroxyethyl)-methacrylat und etwa 25 % Glycerindiallylether zugrunde liegt.

Diese polymere Vorstufe wird analog Beispiel 1 (b) zu einem Fotolack formuliert.

Analog Beispiel 6 erhält man nach Bestrahlung ein kantenscharfes Bild mit einer Auflösung von weniger als 3 µm.

Beispiel 8

Analog Beispiel 1 (a) werden 36,9 g Pyromellitsäuredianhydrid mit 10 g 2-Hydroxyethyl-allyl-thioether und 33 g (2-Hydroxyethyl)-methacrylat verestert. Der Ester wird anschließend in analoger Weise zu Beispiel 1 (a) mit 4,4'-Diaminodiphenylether umgesetzt. Man erhält eine polymere Vorstufe, in der etwa 75 % der esterartig an Carboxylgruppen gebundenen strahlungsreaktiven Reste (2-Hydroxyethyl)-methacrylat und etwa 25 % 2-Hydroxyethyl-allyl-thioether zugrunde liegt. Diese wird analog Beispiel 1 (b) zu einem Fotolack formuliert.

Bei der Anwendung analog Beispiel 6 erhält man nach Bestrahlung ein kantenscharfes Bild.

Vergleichsbeispiel

Analog Beispiel 1 (a) wird eine polymere Vorstufe hergestellt, in der 100 % der esterartig an Carboxylgruppen gebundenen strahlungsreaktiven Reste (2-Hydroxyethyl)-methacrylat zugrunde liegt. Diese wird zu einem Fotolack analog Beispiel 1 (b) formuliert.

Bei der Anwendung analog Beispiel 1 (c) muß die Bestrahlungsdauer auf mindestens 180 Sekunden erhöht werden, um ein kantenscharfes Bild zu erhalten.

Merck Patent Gesellschaft
mit beschränkter Haftung
D a r m s t a d t

Patentansprüche

1.   Fotolacke zur Ausbildung von Reliefstrukturen
     aus hochwärmebeständigen Polymeren, enthaltend
     esterartig an Carboxylgruppen gebundene strahlungsreaktive Reste tragende, lösliche polymere
     Vorstufen, dadurch gekennzeichnet, daß mindestens
     3 % der esterartig an Carboxylgruppen gebundenen
     strahlungsreaktiven Reste mehrwertige Alkohole
     zugrunde liegen, in denen eine oder mehrere Hydroxygruppen mit Allylalkohol und/oder Allylthiol verethert sind und die zur Veresterung eine
     freie Hydroxygruppe enthalten.

2.  Verwendung von mehrwertigen Alkoholen, in denen
    eine oder mehrere Hydroxygruppen mit Allylalkohol und/oder Allylthiol verethert sind und die
    mindestens eine freie Hydroxygruppe enthalten,
    zur Herstellung von esterartig an Carboxylgruppen gebundene, strahlungsreaktive Reste
    tragenden, löslichen polymeren Vorstufen für
    Fotolacke.

3.  Verfahren zur Herstellung von Reliefstrukturen
    aus hochwärmebeständigen Polymeren durch Auftragen von Fotolacken, enthaltend esterartig an
    Carboxylgruppen gebundene strahlungsreaktive
    Reste tragende, lösliche polymere Vorstufen, in
    Form einer Schicht oder Folie auf ein Substrat,
    Trocknen der Schicht oder Folie, Bestrahlen der
    strahlungsempfindlichen Schicht oder Folie durch
    Negativvorlagen, Herauslösen oder Abziehen der
    nicht bestrahlten Schicht- oder Folienteile und
    gegebenenfalls anschließendes Tempern der er-
    haltenen Reliefstrukturen, dadurch gekennzeich-
    net, daß man Fotolacke nach Anspruch 1 ver-
    wendet.